# EUROPÄISCHE PATENTANMELDUNG

(11) **EP 3 373 709 A1**
(43) Veröffentlichungstag der Anmeldung: **12.09.2018**
(21) Anmeldenummer: 17159505.1
(22) Anmeldetag: 07.03.2017
(51) Int. Cl.: H05K 1/02, H01L 23/498, H01L 23/495, H05K 3/28

(54) **TRAEGERSUBSTRAT FUER EINE LICHTANWENDUNG UND VERFAHREN ZUR HERSTELLUNG EINES TRAEGERSUBSTRATS**

(71) Anmelder: Heraeus Deutschland GmbH & Co. KG, 63450 Hanau (DE)
(72) Erfinder: Ditzel, Eckhard, 63589 Linsengericht (DE); Benedikt, Michael, 63543 Neuburg (DE); Krueger, Frank, 61130 Nidderau (DE); Walter, Siegfried, 63571 Gelnhausen-Höchst (DE); Muschelknautz, Christian, 64291 Darmstadt (DE)
(74) Vertreter: Heraeus IP

(57) **Zusammenfassung**

Ein Trägersubstrat für eine Lichtanwendung, aufweisend zumindest eine elektrisch leitende Trägerschicht (3), wobei die Trägerschicht (3) als vorbestimmtes Muster mit Anschlusspunkten (7a, 7b) für Leuchtmittel ausgestaltet ist und zumindest bereichsweise zumindest drei zumindest abschnittsweise mäanderförmige Leiterbahnen (5a, 5b, 5c) in dem vorbestimmten Muster ausgebildet sind zur Verschaltung der Leuchtmittel, wobei eine äußere Sinuosität zumindest einer äußeren Leiterbahn (5a, 5b) größer ist als eine innere Sinuosität zumindest einer inneren Leiterbahn (5c). Auch betrifft die vorliegende Erfindung ein Verfahren zur Herstellung eines Trägersubstrats.

## Beschreibung

Die vorliegende Erfindung betrifft ein Trägersubstrat für eine Lichtanwendung aufweisend zumindest eine elektrisch leitende Trägerschicht, wobei die Trägerschicht als vorbestimmtes Muster mit Anschlusspunkten für Leuchtmittel ausgestaltet ist und zumindest bereichsweise zumindest drei zumindest abschnittsweise mäanderförmige Leiterbahnen in dem vorbestimmten Muster ausgebildet sind zur Verschaltung der Leuchtmittel. Weiterhin betrifft die vorliegende Erfindung ein Verfahren zur Herstellung eines Trägersubstrats.

Im Stand der Technik werden solche Trägersubstrate zur Anordnung und elektrischen Versorgung von Leuchtmitteln genutzt. Mehrere Leuchtmittel sind gewöhnlich abhängig von dem gewünschten Einsatzgebiet in einer Reihen- und/oder Parallelschaltung angeordnet. Häufig werden solche Trägersubstrate für Lichtanwendungen eingesetzt, in denen lediglich ein begrenzter Einbauraum für die Lichtanwendung zur Verfügung steht, da die Trägerschicht mit den Leiterbahnen in einem gewissen Bereich mechanisch verformbar ist. Die Leiterbahnen sorgen somit dafür, dass die Leuchtmittel relativ zueinander in dem Bereich der Verformbarkeit bewegt werden können. Häufige Einsatzgebiete sind beispielsweise Lichtanwendungen in Fahrzeugen, Lichtanwendungen mit Beleuchtungskörpern, die auf Grund Ihrer geschwungenen Form einen markenbezogenen Wiedererkennungseffekt erzeugen können, oder allgemein in Beleuchtungskörpern für Lampen.

Beispielsweise wird in der US 9,247,648 ein Trägersubstrat mit einer flexiblen Trägerschicht beschrieben. Auf der Trägerschicht können elektronische Komponenten, beispielsweise Leuchtmittel, angeordnet werden. Die Leiterbahnen, welche die elektronischen Komponenten untereinander verbinden, können in darin beschriebenen Ausführungsbeispielen mäanderförmig ausgestaltet sein, um die elektrischen Komponenten elastisch zu verbinden.

Ein weiteres aus dem Stand der Technik bekanntes Trägersubstrat wird in der WO 2013/144858 A1 beschrieben. Hier sind Leuchtmittel in gewissen Abständen auf einer freistehenden flexiblen Trägerschicht angeordnet. Wegen der freistehenden Ausgestaltung der Leiterbahnen können die Leuchtmittel auf dem Trägersubstrat relativ zueinander verbogen werden.

Allerdings weisen die aus dem Stand der Technik bekannten Trägersubstrate mit flexiblen Trägerschichten häufig nur eine geringe Flexibilität und/oder Biegbarkeit auf. Soweit die aus dem Stand der Technik bekannten Trägersubstrate überhaupt biegbar sind, können die Trägersubstrate lediglich in eine Raumrichtung, beispielsweise senkrecht zur Oberfläche der Trägersubstrate gebogen werden. Im Falle, dass die aus dem Stand der Technik bekannten Trägersubstrate in eine zweite Raumrichtung gebogen werden, besteht die Gefahr, dass die Leiterbahnen abreisen, so dass eine zuverlässige Funktion der auf dem Trägersubstrat angeordneten Leuchtmittel nicht mehr gewährleistet werden kann.

Aufgabe der vorliegenden Erfindung ist es daher, ein verbessertes Trägersubstrat und Verfahren zur Herstellung eines verbesserten Trägersubstrats bereitzustellen, das in unterschiedliche Bewegungsrichtungen flexibel biegbar ist.

Diese Aufgabe wird erfindungsgemäß durch ein Trägersubstrat gemäß des Gegenstands des Patentanspruchs 1 gelöst.

Das erfindungsgemäße Trägersubstrat für eine Lichtanwendung weist hierfür auf: zumindest eine elektrisch leitende Trägerschicht, wobei die Trägerschicht als vorbestimmtes Muster mit Anschlusspunkten für Leuchtmittel ausgestaltet ist und zumindest bereichsweise zumindest drei zumindest abschnittsweise mäanderförmige Leiterbahnen in dem vorbestimmten Muster ausgebildet sind zur Verschaltung der Leuchtmittel, wobei eine äußere Sinuosität zumindest einer äußeren Leiterbahn größer ist als eine innere Sinuosität zumindest einer inneren Leiterbahn.

Der Begriff "vorbestimmtes Muster" kann in diesem Zusammenhang dafür verwendet werden, um eine Leiterbahngeometrie mit Anschlusspunkten zu bezeichnen, wobei das Material zwischen benachbarten Leiterbahnen entfernt ist, um eine Isolierung der Leiterbahnen gegeneinander zu gewährleisten. Unter den Begriff "Leuchtmittel" kann jedes elektrische Betriebsmittel fallen, das dazu dient elektromagnetische Strahlung in einem bestimmten Wellenlängenbereich zu erzeugen. Als Leuchtmittel können daher Glühlampen, Leuchtstoffröhren, Halogen-Metalldampflampen, Leuchtdioden, LEDs, und/oder Organische Leuchtdioden, OLEDs, verwendet werden.

Als "mäanderförmig" können Leiterbahnen bezeichnet werden, die einen im Wesentlichen gleichmäßigen bogenförmig geschwungenen Verlauf auf dem Trägersubstrat haben. Eine Kurve einer mäanderförmigen Leiterbahn kann deshalb mindestens zwei Umkehrpunkte haben. Der Verlauf der Leiterbahnen kann im Wesentlichen dem Verlauf einer trigometrischen Funktion folgen. Alternativ oder ergänzend hierzu, können die Bögen der mäanderförmigen Leiterbahn zumindest abschnittsweise auch kreisförmig und/oder elliptisch ausgestaltet sein.

Die Begriffe "äußere Sinuosität" und "innere Sinuosität" können verwendet werden, um die Intensität des Mäandrierens zu definieren. Die Sinuosität kann als Quotient zwischen der Länge einer Leiterbahn, bzw. der gestreckten Länge des Mäanders, und der geradlinigen Distanz zwischen Anfangs- und Endpunkt der Leiterbahn mit Mäander, bzw. der überbrückenden Distanz mit Mäander, berechnet werden. Hier können die Anfangs- und Endpunkte jeweils an benachbarten Anschlusspunkten angeordnet sein. Alternativ, in einem weiteren Beispiel, kann auch eine Vielzahl von benachbarten Anschlusspunkten zwischen dem Anfangs- und Endpunkt liegen. Zur Bestimmung der Sinuosität ist es in einem Beispiel unwesentlich, ob die Amplitude des geschwungenen Verlaufs über die überbrückte Distanz im Wesentlichen gleich bleibt, oder abnehmend verläuft, zunehmend verläuft, bzw. unterschiedliche Werte über die überbrückte Distanz einnimmt.

Erfindungsgemäß ist die äußere Sinuosität zumindest einer äußeren Leiterbahn größer als die innere Sinuosität zumindest einer inneren Leiterbahn. Vorteilhaft kann hierdurch das Trägersubstrat in mehr als eine Raumrichtung gebogen werden, ohne dass die Leiterbahnen beschädigt werden. Im Speziellen liegt der Erfindung die überraschende Erkenntnis zu Grunde, dass wenn die Sinuosität der äußeren Leiterbahn größer ist als die Sinuosität der inneren Leiterbahn, eine gute Biegbarkeit in verschiedene Raumrichtungen erzielt werden kann, während gleichzeitig der Platzbedarf der Leiterbahnen optimiert wird. Es hat sich gezeigt, dass erfindungsgemäße Trägersubstrate, je nach Aufbau, in Winkeln von bis zu ±45° zerstörungsfrei gebogen werden können.

Mit der Erfindung ist es erstmalig gelungen die Leiterbahnen in einer freistehenden Trägerschicht so anzuordnen, dass die Leiterbahnen flexibel biegbar sind und gleichzeitig der Platzbedarf der Leiterbahnen optimiert wird.

In einem Beispiel ist zumindest eine Leiterbahn, bevorzugt alle Leiterbahnen, zwischen zwei benachbarten Anschlusspunkten zumindest bereichsweise mäanderförmig ausgestaltet und ansonsten im Wesentlichen geradlinig ausgestaltet.

Vorteilhaft verbleibt hierdurch um die Anschlusspunkte herum genug Platz für eine entsprechende Anschlussgeometrie, während der Bereich zwischen den Anschlusspunkten biegbar ist. Auch kann, abhängig von der gewünschten Anwendung, lediglich ein Teilbereich der Leiterbahnen mit Mäander ausgeführt sein. Beispielsweise können nur 50% oder weniger der Leiterbahnstrecke als Mäander ausgestaltet sein.

In einem weiteren Beispiel entspricht eine Breite zumindest einer der Leiterbahnen, bevorzugt die Breite aller drei Leiterbahnen, im Wesentlichen einer Dicke der Trägerschicht, und/oder wobei die Leiterbahnen zumindest abschnittsweise im Wesentlichen in einer Ebene und parallel zueinander angeordnet sind.

Vorteilhaft kann durch die Dimensionierung einer Breite einer der Leiterbahnen, so dass der Wert für die Breite im Wesentlichen einer Dicke, bzw. Höhe, der Trägerschicht entspricht optimale Biegbarkeit erreicht werden. Durch die parallele Anordnung der Leiterbahnen zueinander kann eine platzsparende Anordnung der Leuchtmittel erreicht werden.

In einem weiteren Beispiel sind die Leiterbahnen angepasst eine zumindest zweipolige Energieversorgung der Lichtanwendung und eine Reihenschaltung von Leuchtmitteln bereitzustellen, und/oder wobei eine Vielzahl von Leuchtmitteln, insbesondere von Leuchtdioden, LEDs, auf dem Trägersubstrat angeordnet ist.

Zur optimalen Ausnutzung des zur Verfügung stehenden Platzes können die äußeren Leiterbahnen als Sammelschienen für die Energieversorgung, beispielsweise als Pluspol und Minuspol verwendet werden, während zwischen den äußeren Leiterbahnen eine innere Leiterbahn angeordnet ist, mit einer geringeren Sinuosität, die eine Reihenschaltung von Leuchtmitteln ermöglicht.

In einem weiteren Beispiel umfasst die Trägerschicht einen Leadframe.

Der Leadframe kann auch als Anschluss-Rahmen bezeichnet werden und kann beispielsweise ein metallischer Leitungsträger in Form eines Rahmens oder Kamms ausgestaltet sein. Der Leadframe kann eine freistehende Struktur aufweisen. Vorteilhaft kann ein derartig biegbarer Leadframe günstiger hergestellt werden als beispielsweise folienbasierte Lösungen.

In einem weiteren Beispiel umfasst die Trägerschicht ein Kupfermaterial und/oder eine Kupferlegierung.

Beispielsweise kann der Leadframe aus einer Kupferfolie gefertigt, bzw. ausgestanzt werden. Vorteilhaft hat Kupfer gute elektrische und mechanische Eigenschaften.

In einem Beispiel weist die Trägerschicht eine Dicke von 50 bis 400 µm, insbesondere eine Dicke von 100 bis 120 µm, auf.

Vorteilhaft haben Trägerschichten mit Dicken in diesen Bereichen sehr gute mechanische Eigenschaften und sind gleichzeitig materialsparend herstellbar.

In noch einem weiteren Beispiel liegt die innere Sinuosität in einem Bereich von 1.2 bis 2.0, und/oder die äußere Sinuosität in einem Bereich von größer 2.0 bis 4.0.

Durch dieses Verhältnis der bogenmäßig geschwungenen Ausgestaltungen der Leiterbahnen relativ zueinander, können besonders vorteilhafte Ergebnisse hinsichtlich der Biegbarkeit des Trägersubstrats/Trägerschicht erzielt werden. Es hat sich als vorteilhaft herausgestellt, dass ein Verhältnis im Wesentlichen von 1:2 der inneren Sinuosität zu der äußeren Sinuosität gute Biegeeigenschaften bei gleichzeitiger Materialeinsparung ermöglicht.

In einem Beispiel weist die innere Leiterbahn eine Amplitude des Mäanders als Vielfaches der Länge der inneren Leiterbahn in einem Bereich von 0.01 bis 0.5 auf, und/oder
die äußere Leiterbahn weist eine Amplitude des Mäanders als Vielfaches der Länge der äußeren Leiterbahn in einem Bereich von 0.5 bis 2.0 auf, und/oder
die Anzahl der Mäanderkurven der inneren Leiterbahn als Vielfaches der Länge der inneren Leiterbahn liegt in einem Bereich von 0.5 bis 1.5, und/oder
die Anzahl der Mäanderkurven der äußeren Leiterbahn als Vielfaches der Länge der äußeren Leiterbahn liegt in einem Bereich von 1.5 bis 4.

In einem weiteren Beispiel ist zumindest eine Folie aufweisend isolierendes Material, insbesondere eine Polymerfolie, zumindest bereichsweise auf zumindest einer Seite des Trägerschicht angeordnet, bevorzugt ist jeweils eine Polymerfolie auf jeder Seite der Trägerschicht angeordnet, weiter bevorzugt deckt die Polymerfolie im Wesentlichen eine Seite der Trägerschicht vollständig ab.

Vorteilhaft kann die Folie die Trägerschicht stabilisieren und die Leiterbahnen isolieren. Auch kann die Folie ein Muster aufweisen, das im Wesentlichen dem vorbestimmten Muster der Trägerschicht entspricht. Je nach Anwendungsgebiet kann die Folie auf nur einer Seite, bzw. Oberfläche der Trägerschicht angeordnet sein, oder auf beiden Seiten der Trägerschicht können Folien angeordnet sein.

In diesem Beispiel weist die Polymerfolie zumindest bereichsweise zumindest einen Einschnitt, insbesondere einen Spalt in einem Material der Polymerfolie, bevorzugt eine Vielzahl von Einschnitten auf, insbesondere liegt der Einschnitt in einem Bereich zumindest einer der Leiterbahnen.

Dieser Einschnitt kann vorteilhaft in das Material eingebracht werden, um die Leiterbahnen, bzw. einen Bereich, der um die Leiterbahnen herum liegt, mechanisch zu entlasten.

In noch einem weiteren Beispiel umfasst ein Anschlusspunkt aus der Vielzahl von Anschlusspunkten zumindest zwei Kontakte zur elektrischen Anbindung zumindest eines Leuchtmittels aus der Vielzahl von Leuchtmitteln.

Die beiden Kontakte können beispielsweise als Unterbrechung in dem Material der Trägerschicht angeordnet sein.

In einem weiteren Beispiel ist zumindest ein Stabilisierungselement, insbesondere eine Versteifung, um zumindest einen Anschlusspunkt angeordnet. Das Stabilisierungselement kann in einem weiteren Beispiel zumindest ein Metallelement und/oder zumindest ein Kunststoffelement, insbesondere einen Metallring und/oder Kunststoffring, umfassen.

Vorteilhaft kann dadurch die Verbindung von dem Leuchtmittel mit dem Material der Trägerschicht zuverlässig gewährleistet werden. Im Speziellen wird der Kontakt zwischen Leuchtmittel durch die Versteifung auch dann noch zuverlässig gewährleistet, wenn das Trägersubstrat stark gebogen wird.

Die Erfindung schlägt auch ein Verfahren vor zum Herstellen eines Trägersubstrats für eine Lichtanwendung, aufweisend die Schritte:
Bereitstellen zumindest eine elektrisch leitende Trägerschicht; und

Einbringen in die Trägerschicht ein vorbestimmtes Muster mit Anschlusspunkten für Leuchtmittel und zumindest bereichsweise zumindest drei zumindest abschnittsweise mäanderförmige Leiterbahnen zur Verschaltung der Leuchtmittel, wobei eine äußere Sinuosität zumindest einer äußeren Leiterbahn größer ist als eine innere Sinuosität zumindest einer inneren Leiterbahn.

In einem Beispiel weist das Verfahren den Schritt auf:
Aufbringen zumindest eines Fixierungselements auf die erste Seite zumindest bereichsweise um das Kontaktierungselement herum, wobei das Fixierungselement angepasst ist das Elektronikbauteil zu kontaktieren, insbesondere die erste Seite mit dem Elektronikbauteil mechanisch zu verbinden.

In noch einem Beispiel weist das Einbringen in die Trägerschicht auf:
Einbringen mittels eines Stanzverfahrens, eines Laserschneidverfahrens, eines Ätzverfahrens, und/oder mittels eines Verfahrens welches eine Kombination aus den genannten Verfahren nutzt.

Durch diese Verfahren kann das vorbestimmt Muster vorteilhaft schnell und akkurat in die Trägerschicht eingebracht werden.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
- Figur 1: eine schematische Ansicht eines Bereichs des Trägersubstrats gemäß einer Ausführungsform der Erfindung;
- Figur 2: eine schematische Ansicht einer Verschaltung der Leuchtmittel gemäß einer Ausführungsform der Erfindung; und
- Figur 3: ein Verfahren zum Herstellen eines Trägersubstrats gemäß einer Ausführungsform der Erfindung.

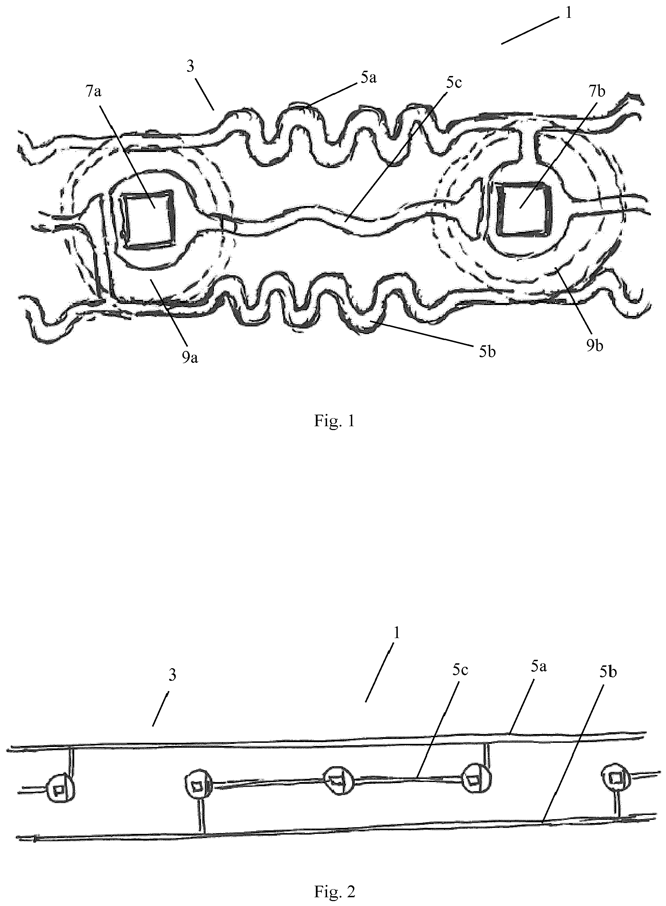

Figur 1 zeigt eine schematische Ansicht eines Bereichs des Trägersubstrats 1 gemäß einer Ausführungsform der Erfindung.

Wie es in Figur 1 gezeigt wird, weist das Trägersubstrat 1 eine Trägerschicht 3 auf. Die Trägerschicht 3 kann aus einem elektrisch leitenden Material gefertigt werden. Beispielsweise kann die Trägerschicht 3 ein Leadframe sein, der als ein metallischer Leitungsträger in Form eines Rahmens oder Kamms ausgestaltet ist. Die in Figur 1 gezeigte Struktur der Trägerschicht 3 kann mittels eines Stanzverfahrens, eines Laserschneidverfahrens, oder eines Ätzverfahrens in der Trägerschicht 3 ausgeformt werden. Die Trägerschicht 3 kann beispielsweise aus einer Kupferfolie gefertigt sein. Der Fachmann weiß aber, dass die Trägerschicht 3 auch aus einem anderen Metall, einer Legierung oder aus jeder leitfähigen Folie gefertigt sein kann, die mechanisch zumindest teilweise verformbar ist.

Weiterhin zeigt Figur 1 die abschnittsweisen mäanderförmigen Leiterbahnen 5a, 5b, 5c in der Trägerschicht 3. Das Material der Trägerschicht 3 zwischen den Leiterbahnen 5a, 5b, 5c kann mittels eines zuvor genannten Verfahrens entfernt worden sein, so dass die Leiterbahnen 5a; 5b, 5c als freistehende Strukturen ausgebildet werden und gegeneinander isoliert sind. Aus Figur 1 geht hervor, dass die äußeren Leiterbahnen 5a, 5b eine größere Sinuositat aufweisen, als die innere Leiterbahn 5c. In der gezeigten Ausführungsform werden drei Leiterbahnen 5a, 5b, 5c verwendet. In weiteren (nicht gezeigten) Ausführungsformen können mehr als nur drei Leiterbahnen zum Einsatz kommen, wobei die äußeren Leiterbahnen eine größere Sinuosität haben als die inneren Leiterbahnen. Die größere Sinuosität der äußeren mäanderförmigen Leiterbahnen 5a, 5b ermöglichen eine stärkere Biegsamkeit, da an den Rändern der Trägerschicht 3 gewöhnlich höhere Biegekräfte angreifen als im Zentrum der Trägerschicht 3.

In Figur 1 werden auch exemplarisch zwei Anschlusspunkte 7a, 7b zur elektrischen Anbindung von Leuchtmitteln gezeigt. Die Anschlusspunkte 7a, 7b können im Wesentlichen aus zwei Kontakten gebildet werden, die als Unterbrechung in dem Material der Trägerschicht 3 ausgestaltet sein können.

Weiterhin zeigen die beiden gestrichelten Kreise, dass jeweils ein Stabilisierungselement 9a, 9b, beispielsweise eine Versteifung um zumindest einen Anschlusspunkt 7a, 7b angeordnet sein kann. Das Stabilisierungselement 9a, 9b kann hierfür beispielsweise ein Metallelement und/oder zumindest ein Kunststoffelement umfassen.

Figur 2 zeigt eine schematische Ansicht einer Verschaltung der Leuchtmittel gemäß einer Ausführungsform der Erfindung.

In der in Figur 2 gezeigten Ausführungsform sind, zum Zwecke der Vereinfachung, die Leiterbahnen ohne mäanderförmige Abschnitte gezeigt. In der Ausführungsform sind jeweils drei Leuchtmittel in Reihe geschaltet, die beiden äußeren Leiterbahnen 5a, 5b können mit einer zweipoligen Spannungs-/Stromquelle verbunden sein. Die innere Leiterbahn 5c kann jeweils zwischen drei Leuchtmitteln angeordnet sein, so dass die Leuchtmittel in Reihe geschaltet sind.

Der Fachmann weiß aber, dass je nach gewünschtem Einsatzgebiet mehr oder weniger Leuchtmittel in Reihe/Parallel zueinander verschaltet werden können.

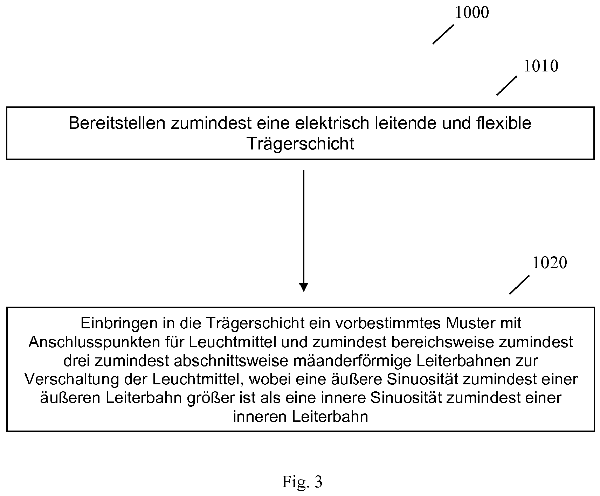

Figur 3 zeigt ein Verfahren zum Herstellen eines Trägersubstrats gemäß einer Ausführungsform der Erfindung. Das Verfahren weist die Schritte auf: Bereitstellen 1010 zumindest eine elektrisch leitende und flexible Trägerschicht; und Einbringen 1020 in die Trägerschicht ein vorbestimmtes Muster mit Anschlusspunkten für Leuchtmittel und zumindest bereichsweise zumindest drei zumindest abschnittsweise mäanderförmige Leiterbahnen zur Verschaltung der Leuchtmittel, wobei eine äußere Sinuosität zumindest einer äußeren Leiterbahn größer ist als eine innere Sinuosität zumindest einer inneren Leiterbahn.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

### Bezugszeichenliste

- 1: Trägersubstrat
- 3: Trägerschicht
- 5a, 5b, 5c: Leiterbahn
- 7a, 7b: Anschlusspunkt
- 9a, 9b: Stabilisierungselement

- 1000: Verfahren zum Herstellen eines Trägersubstrats
- 1010: Bereitstellen
- 1020: Einbringen

## Patentansprüche

1. Ein Trägersubstrat für eine Lichtanwendung, aufweisend zumindest eine elektrisch leitende Trägerschicht (3), wobei die Trägerschicht (3) als vorbestimmtes Muster mit Anschlusspunkten (7a, 7b) für Leuchtmittel ausgestaltet ist und zumindest bereichsweise zumindest drei zumindest abschnittsweise mäanderförmige Leiterbahnen (5a, 5b, 5c) in dem vorbestimmten Muster ausgebildet sind zur Verschaltung der Leuchtmittel,
**dadurch gekennzeichnet, dass**
eine äußere Sinuosität zumindest einer äußeren Leiterbahn (5a, 5b) größer ist als eine innere Sinuosität zumindest einer inneren Leiterbahn (5c).

2. Trägersubstrat nach Anspruch 1, **dadurch gekennzeichnet, dass** zumindest eine Leiterbahn (5a, 5b, 5c), bevorzugt alle Leiterbahnen (5a, 5b, 5c), zwischen zwei benachbarten Anschlusspunkten zumindest bereichsweise mäanderförmig ausgestaltet ist/sind und ansonsten im Wesentlichen geradlinig ausgestaltet ist/sind.

3. Trägersubstrat nach Anspruch 1 oder 2, **dadurch gekennzeichnet, dass** eine Breite zumindest einer der Leiterbahnen (5a, 5b, 5c), bevorzugt die Breite aller drei Leiterbahnen (5a, 5b, 5c), im Wesentlichen einer Dicke der Trägerschicht (3) entspricht, und/oder wobei die Leiterbahnen (5a, 5b, 5c) zumindest abschnittsweise im Wesentlichen in einer Ebene und parallel zueinander angeordnet sind.

4. Trägersubstrat nach einem der vorhergehenden Ansprüche, **dadurch gekennzeichnet, dass** die Leiterbahnen (5a, 5b, 5c) angepasst sind eine zumindest zweipolige Energieversorgung der Lichtanwendung und eine Reihenschaltung von Leuchtmitteln bereitzustellen, und/oder wobei eine Vielzahl von Leuchtmitteln, insbesondere von Leuchtdioden, LEDs, auf dem Trägersubstrat angeordnet ist.

5. Trägersubstrat nach einem der vorangehenden Ansprüche, **dadurch gekennzeichnet, dass** die Trägerschicht (3) einen Leadframe umfasst, und/oder
die Trägerschicht (3) ein Kupfermaterial und/oder eine Kupferlegierung umfasst.

6. Trägersubstrat nach einem der vorangehenden Ansprüche, **dadurch gekennzeichnet, dass** die Trägerschicht (3) eine Dicke von 50 bis 400 µm, insbesondere eine Dicke von 100 bis 120 µm, aufweist.

7. Trägersubstrat nach einem der vorangehenden Ansprüche, **dadurch gekennzeichnet, dass** die innere Sinuosität in einem Bereich von 1.2 bis 2.0 liegt, und/oder die äußere Sinuosität in einem Bereich von größer 2.0 bis 4.0 liegt.

8. Trägersubstrat nach einem der vorangehenden Ansprüche, **dadurch gekennzeichnet, dass** die innere Leiterbahn (5c) eine Amplitude des Mäanders als Vielfaches der Länge der inneren Leiterbahn (5c) in einem Bereich von 0.01 bis 0.5 aufweist, und/oder die äußere Leiterbahn (5a, 5b) eine Amplitude des Mäanders als Vielfaches der Länge der äußeren Leiterbahn (5a, 5b) in einem Bereich von 0.5 bis 2.0 aufweist, und/oder die Anzahl der Mäanderkurven der inneren Leiterbahn (5c) als Vielfaches der Länge der inneren Leiterbahn (5c) in einem Bereich von 0.5 bis 1.5 liegt, und/oder die Anzahl der Mäanderkurven der äußeren Leiterbahn (5a, 5b) als Vielfaches der Länge der äußeren Leiterbahn (5a, 5b) in einem Bereich von 1.5 bis 4 liegt.

9. Trägersubstrat nach einem der vorangehenden Ansprüche, **dadurch gekennzeichnet, dass** zumindest eine Folie aufweisend isolierendes Material, insbesondere eine Polymerfolie, zumindest bereichsweise auf zumindest einer Seite des Trägerschicht (3) angeordnet ist, bevorzugt ist jeweils eine Polymerfolie auf jeder Seite der Trägerschicht (3) angeordnet, weiter bevorzugt deckt die Polymerfolie im Wesentlichen eine Seite der Trägerschicht (3) vollständig ab.

10. Trägersubstrat nach Anspruch 9, **dadurch gekennzeichnet, dass** die Polymerfolie zumindest bereichsweise zumindest einen Einschnitt, insbesondere einen Spalt in einem Material der Polymerfolie, bevorzugt eine Vielzahl von Einschnitten aufweist, insbesondere liegt der Einschnitt in einem Bereich zumindest einer der Leiterbahnen (5a, 5b, 5c).

11. Trägersubstrat nach einem der vorangehenden Ansprüche, **dadurch gekennzeichnet, dass** ein Anschlusspunkt (7a, 7b) aus der Vielzahl von Anschlusspunkten (7a, 7b) zumindest zwei Kontakte zur elektrischen Anbindung zumindest eines Leuchtmittels aus der Vielzahl von Leuchtmitteln umfasst.

12. Trägersubstrat nach einem der vorangehenden Ansprüche, **dadurch gekennzeichnet, dass** zumindest ein Stabilisierungselement (9a, 9b), insbesondere eine Versteifung, um zumindest einen Anschlusspunkt (7a, 7b) angeordnet ist.

13. Trägersubstrat nach einem der vorangehenden Ansprüche, **dadurch gekennzeichnet, dass** das Stabilisierungselement (9a, 9b) zumindest ein Metallelement und/oder zumindest ein Kunststoffelement, insbesondere einen Metallring und/oder Kunststoffring, umfasst.

14. Ein Verfahren zum Herstellen eines Trägersubstrats für eine Lichtanwendung, aufweisend die Schritte:
Bereitstellen (1010) zumindest eine elektrisch leitende Trägerschicht (3); und
Einbringen (1020) in die Trägerschicht (3) ein vorbestimmtes Muster mit Anschlusspunkten (7a, 7b) für Leuchtmittel und zumindest bereichsweise zumindest drei zumindest abschnittsweise mäanderförmige Leiterbahnen (5a, 5b, 5c) zur Verschaltung der Leuchtmittel, wobei eine äußere Sinuosität zumindest einer äußeren Leiterbahn (5a, 5b) größer ist als eine innere Sinuosität zumindest einer inneren Leiterbahn (5c).

15. Das Verfahren nach Anspruch, **dadurch gekennzeichnet, dass** das Einbringen in die Trägerschicht (3) aufweist:
Einbringen (1020) mittels eines Stanzverfahrens, eines Laserschneidverfahrens, eines Ätzverfahrens, und/oder mittels eines Verfahrens welches eine Kombination aus den genannten Verfahren nutzt.
